# EUROPÄISCHE PATENTSCHRIFT

(11) **EP 3 943 905 B1**
(45) Veröffentlichungstag und Bekanntmachung des Hinweises auf die Patenterteilung: **05.10.2022**
(21) Anmeldenummer: 20186872.6
(22) Anmeldetag: 21.07.2020
(51) Int. Cl.: G01L 19/00, G01D 11/30

(54) **VERBINDUNGSVORRICHTUNG ZUM VERBINDEN EINES SENSORS MIT EINER EIN FLUID ENTHALTENDEN EINHEIT**
CONNECTING DEVICE FOR CONNECTING A SENSOR TO A FLUID-CONTAINING UNIT
DISPOSITIF DE RACCORDEMENT PERMETTANT DE RACCORDER UN CAPTEUR À UNE UNITÉ CONTENANT UN FLUIDE

(43) Veröffentlichungstag der Anmeldung: 26.01.2022
(73) Patentinhaber: SICK AG, 79183 Waldkirch (DE)
(72) Erfinder: Graner, Thomas, 79211 Denzlingen (DE); Bleiziffer, Markus, 79110 Freiburg (DE); Urban, Martin, 79541 Lörrach (DE)

(56) Entgegenhaltungen:
- DE-A1-102005 043 346
- US-A1- 2017 268 910
- Filton: "Rotary Unions Swivel Joints Manufactured in the UK with Over 70 Years Experience", , 31 December 2016 (2016-12-31), pages 1-36, XP055885579, Retrieved from the Internet: URL:https://www.filtonltd.com/uploads/DOC5 344FE551F218.pdf [retrieved on 2022-01-31]

## Beschreibung

Die Erfindung betrifft eine Verbindungsvorrichtung zum Verbinden eines Sensors mit einer ein Fluid enthaltenden Einheit gemäß dem Oberbegriff des Anspruchs 1.

In der heutigen Industrie werden fast sämtliche verwendete Einheiten, wie beispielsweise Maschinen oder Behälter, mittels Sensoren überwacht. Ein Einsatz der Sensoren kann durch Richtlinien oder Standardnormen vorgegeben sein, die bei der Auslegung des Einsatzes der Sensoren einzuhalten sind.

Beim Anschluss eines Sensors im Bereich der Lebensmittelindustrie oder bei sterilen Anwendungen ist es erforderlich, dass eine mikrobiologische Kontamination vermieden wird. Eine solche Kontamination kann entstehen, wenn Fluid bzw. Flüssigkeit in einen Totraum eindringt und dort verbleibt. Deshalb ist, wenn Dichtungen oder Membrane verwendet werden, um den Totraum von einem Produktbereich zu trennen, eine Leckageanzeige vorzusehen. Hierbei ist die Leckageanzeige wegen des Abfließens von leckendem Fluid nach unten, an einer möglichst untersten Stelle zu positionieren. Im einfachsten Fall besteht die Leckageanzeige aus einer Leckagebohrung, aus der das leckende Fluid (sichtbar) austreten kann. In diesem Zusammenhang ist unter Totraum ein Hohlraum zwischen der Einheit und dem Sensor zu verstehen, in den aus der Einheit leckende Fluid eintreten kann.

Diese Positionierung der Leckagebohrung ist nicht immer möglich, da wenn die Leckagebohrung an dem Sensor vorgesehen ist und wenn der Sensor an die Einheit anzuschrauben ist, die endgültige Position der Leckagebohrung und die Positionen möglicher Sensoranschlüsse nicht wählbar sind, weil sie von einem Ende des Gewindes abhängen. Andererseits kann die geforderte unterste Position der Leckagebohrung derart gewährleistet werden, dass die Leckagebohrung an der Einheit fest angeordnet ist, beispielsweise durch entsprechendes Schweißen. Dann ist aber eine Dreh-Ausrichtung des an die Einheit anzuschraubenden Sensors nicht möglich, so dass dann die Drehlage des Sensors rein zufällig ist und z.B. insbesondere eine Ablesbarkeit einer Anzeige des Sensors und/oder eine Verkabelung erschwert sind, weil die Anzeige in einem zum Ablesen ungünstigen Winkel positioniert ist bzw. entsprechende Anschlüsse des Sensors für die Verkabelung sich in ungünstiger Lage befinden.

Aus DE 10 2005 043 346 A1 ist eine Verbindungsvorrichtung, insbesondere ein Sensoranschluss, gemäß den Merkmalen des Oberbegriffs des Anspruchs 1 bekannt. DerSensoranschluss umfasst ein Kupplungsglied, das auf ein Common-Rail aufschraubbar ist und einen Niederdruck-Ablaufdurchlassweg aufweist, wobei das Kupplungsglied in der aufgeschraubten Betriebsposition in seiner Position fixiert ist.

Aus der Broschüre "Filton: "Rotary Unions Swivel Joints Manufactured in the UK with Over 70 Years Experience"" ist ein Drehgelenk zum Verbinden einer Fluid Zufluss-Leitung und einer Fluid Abfluss-Leitung bekannt.

Es ist eine Aufgabe der Erfindung, eine Verbindungsvorrichtung zum Verbinden eines Sensors mit einer ein Fluid enthaltenden Einheit zur Verfügung zu stellen, mit der ein einfaches Ausrichten eines Leckage-Auslasses unter Berücksichtigung einer Ausrichtung des Sensors möglich ist.

Die Aufgabe wird erfindungsgemäß gelöst durch eine Verbindungsvorrichtung zum Verbinden eines Sensors mit einer ein Fluid enthaltenden Einheit mit den Merkmalen des Anspruchs 1.

Hierdurch ergibt sich insbesondere der Vorteil, dass das einfache Ausrichten des Leckage-Auslasses mittels des Leckage-Ringes gleichzeitig und unabhängig davon ein einfaches Ausrichten der Anzeige des Sensors in einer optimalen Lage, beispielsweise für eine Ablesbarkeit einer Anzeige des Sensors oder eine Verkabelung des Sensors, möglich ist.

Gemäß einem bevorzugten Ausführungsbeispiel umfasst der erste Montageabschnitt eine Schraubverbindung. Hierdurch ist eine Montage der Verbindungsvorrichtung an die Einheit sehr einfach.

Weiterhin umfasst gemäß einem weiteren bevorzugten Ausführungsbeispiel der zweite Montageabschnitt eine Flanschverbindung, insbesondere eine Tri-Clamp-Verbindung, wodurch eine Montage der Verbindungsvorrichtung an die Einheit und das Ausrichten des Sensors durch Drehen der Verbindungsvorrichtung zusammen mit dem Sensor besonders vereinfacht ist.

Ferner ist es vorteilhaft, dass die Verbindung des ersten Montageabschnitts mit dem Sensor und die Verbindung des zweiten Montageabschnitts mit der Einheit hermetisch dicht ausgebildet ist.

Die der Erfindung zugrundeliegende Aufgabe wird ferner von einem Verfahren zum Montieren eines Sensors mittels einer Verbindungsvorrichtung an eine ein Fluid enthaltende Einheit dadurch gelöst, dass das Verfahren die Schritte umfasst:
a) Montieren des Sensors an einen ersten Montageabschnitt der Verbindungsvorrichtung und Montieren eines zweiten Montageabschnitts der Verbindungsvorrichtung an die Einheit, wobei das Verfahren gekennzeichnet ist, durch:
   b) Ausrichten des Sensors in eine gewünschte Position des Sensors, und
   c) Drehen eines Leckage-Ringes der Verbindungsvorrichtung, um einen am Umfang des Leckage-Ringes vorgesehenen Leckage-Auslass in einen Bereich einer tiefsten Position des Umfangs des Leckage-Ringes in einer Betriebsposition anzuordnen.

Hieraus ergibt sich der Vorteil, dass sowohl der Leckage-Auslass an die unterste Stelle der Verbindung gemäß der Richtlinie oder der Standardnorm positionierbar ist, als auch der Sensor bezüglich seiner Ablesbarkeit oder seiner Verkabelungszugänglichkeit optimal ausgerichtet werden kann.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine schematische perspektivische Teilansicht einer mittels einer erfindungsgemäßen Verbindungsvorrichtung mit einem Sensor verbundenen Einheit,
- Fig. 2a: eine schematische Schnittansicht des in der Figur 1 gezeigten Ausführungsbeispiels,
- Fig. 2b: eine vergrößerte Detailansicht eines Leckage-Auslasses, und
- Fig. 3: eine perspektivische Schnittansicht eines bevorzugten Ausführungsbeispiels der Verbindungsvorrichtung.

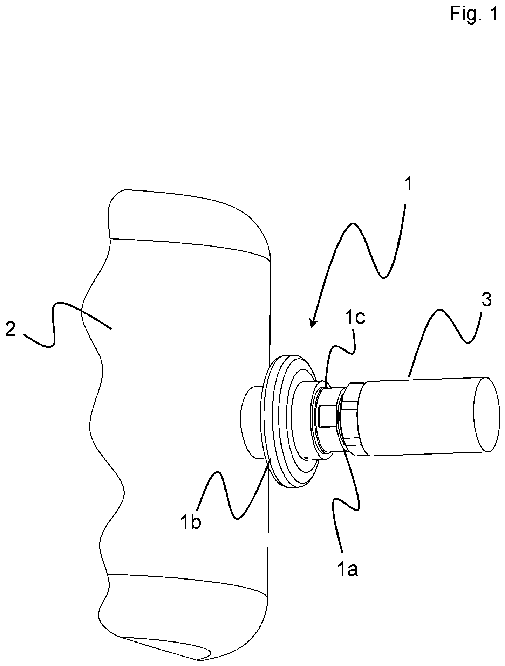

Die Figur 1 zeigt schematisch eine Teilansicht einer ein Fluid enthaltenden Einheit 2, deren Inhalt durch einen Sensor 3 gemessen wird. Die Einheit 2 umfasst insbesondere einen eine Flüssigkeit enthaltenden Behälter, einen Tank, eine Rohrleitung, eine Armatur oder dergleichen, wobei der Sensor 3 einen Druck, eine Temperatur oder irgendeine andere physikalische Größe im Innern der Einheit 2 bestimmt.

Der Sensor 3 ist mittels einer erfindungsgemäßen Verbindungsvorrichtung 1 mit der Einheit 2 verbunden.

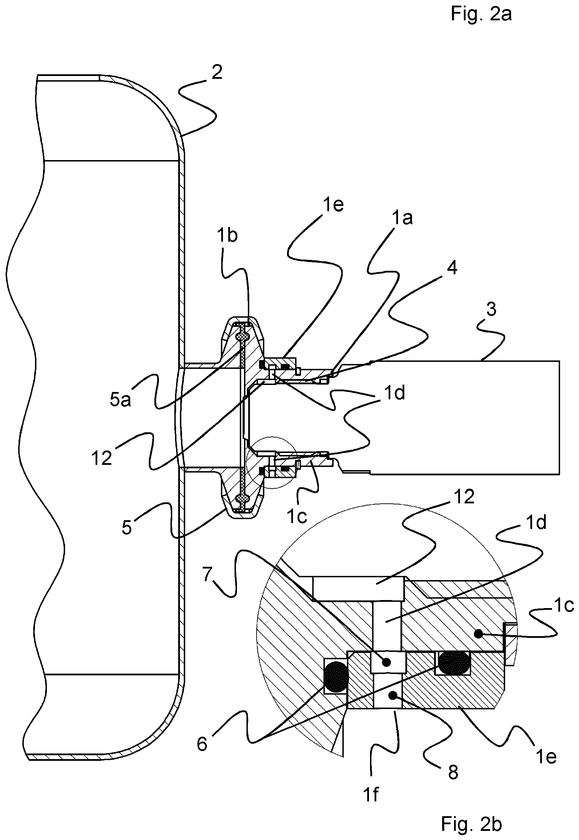

Die Verbindungsvorrichtung 1 umfasst einen ersten Montageabschnitt 1a, an den der Sensor 3 montierbar ist. Ferner umfasst die Verbindungsvorrichtung 1 einen zweiten Montageabschnitt 1b, der an die Einheit 2 montierbar ist. Zwischen dem ersten und dem zweiten Montageabschnitt 1a und 1b liegt ein Mittelbereich 1c, der mehrere, in der Figur 2a dargestellte, Bohrungen 1d auf seinem Umfang aufweist. Hierdurch ist es möglich, dass aus der Einheit 2 ungewollt auslaufende bzw. leckende Flüssigkeit durch eine der Bohrungen 1d ablaufen kann.

Erfindungsgemäß umfasst die Verbindungsvorrichtung 1 einen die Bohrungen 1d des Mittelbereichs 1c abdeckenden Leckage-Ring 1e, der gegenüber dem Mittelbereich 1c abgedichtet und drehbar ist, wobei der Leckage-Ring 1e einen Leckage-Auslass 1f auf seinem Umfang aufweist. Der Leckage-Auslass 1f ist vorgesehen, in einem Bereich einer tiefsten Position des Umfangs des Leckage-Ringes 1e in einer Betriebsposition angeordnet zu sein. Hierdurch ist es möglich, dass der Sensor 3 unabhängig von der Position des Leckage-Auslass 1f durch Drehen der Verbindungsvorrichtung 1 in eine optimale Position zu der Einheit 2 montierbar ist und der Leckage-Auslass 1f des Leckage-Ringes 1e durch Drehen derselben einfach im Bereich einer untersten Position bzw. auf die tiefste Position in der Betriebsposition entsprechend einer Vorgabe einer Richtlinie oder einer Standardnorm eingestellt werden kann.

In der Figur 2a ist eine schematische Schnittansicht des in der Figur 1 dargestellten Ausführungsbeispiels gezeigt. Der erste Montageabschnitt 1a umfasst vorzugsweise eine Schraubverbindung 4, die ein einfaches Anschrauben des Sensors 3 an die Verbindungsvorrichtung 1 ermöglicht. Der zweite Montageabschnitt 1b umfasst eine Flanschverbindung 5, insbesondere eine Tri-Clamp-Verbindung, wodurch die Verbindungsvorrichtung 1 zusammen mit dem Sensor 3 sehr einfach an die Einheit 2 befestigt werden kann. Hierbei kann der Sensor 3 durch einfaches Drehen der Verbindungsvorrichtung 1 in eine optimale Lage bzgl. einer Ablesbarkeit seiner Anzeige oder seiner Kabelzuführung bzw. Verkabelung justiert werden. Nach dem Ausrichten des Sensors 3 kann der Leckage-Auslass 1f durch einfaches Drehen des Leckage-Ringes 1e in die vorgesehene Betriebsposition gebracht werden.

Sowohl die Verbindung zwischen dem ersten Montageabschnitt 1a und dem Sensor 3 als auch zwischen dem zweiten Montageabschnitt 1b und der Einheit 2 sind hermetisch dicht ausgebildet. Auf der Seite des ersten Montageabschnitts 1a ist die Dichtheit durch die Schraubverbindung 4 gewährleistet. Auf der Seite des zweiten Montageabschnitts 1b ist die Dichtheit der Flanschverbindung 5, insbesondere der Tri-Clamp-Verbindung, durch eine Dichtungsanordnung 5a hergestellt. Die Dichtungsanordnung 5a umfasst beispielsweise eine Dichtungsmembran, die die Einheit 2 gegenüber dem Sensor 3 abdichtet.

Im Falle, dass eine Dichtheit der Dichtungsanordnung 5a bzw. der Dichtungsmembran nicht gewährleistet ist, kann ungewollt Flüssigkeit der Einheit 2 in eine Sammelnut 12 einlaufen und durch eine der Bohrungen 1d ablaufen. Die Sammelnut 12 ist auf einer Innenseite des Mittelbereichs 1c der Verbindungsvorrichtung 1 vorgesehen und verbindet alle Bohrungen 1d des Mittelbereichs 1c miteinander.

Wie aus der vergrößerten Detailansicht des Leckage-Auslasses 1f des Leckage-Ringes 1e in der Figur 2b gezeigt, ist der Leckage-Ring 1e mittels zwei Dichtungen 6 gegenüber dem Mittelbereich 1c der Verbindungsvorrichtung 1 abgedichtet. Der Leckage-Ring 1e ist trotz der beiden Dichtungen 6 gegenüber dem Mittelbereich 1c der Verbindungsvorrichtung 1 drehbar. Hierbei weist der Leckage-Ring 1e insbesondere auf einer Innenseite eine umlaufende Nut 7 auf, die breiter als die Bohrung 1d des Mittelbereichs 1c der Verbindungsvorrichtung 1 ausgebildet ist und sämtliche Bohrungen 1d des Mittelbereichs 1c abdeckt. Mit der Nut 7 ist eine radial nach außen gerichtete Auslassbohrung 8 verbunden, so dass die Nut 7 zusammen mit der Auslassbohrung 8 den Leckage-Auslass 1f des Leckage-Ringes 1d bildet.

Dadurch, dass die Nut 7 alle Bohrungen 1d des Mittelbereichs 1c abdeckt und die mit der Nut 7 verbundene Auslassbohrung 8 im Bereich der tiefsten Position des Leckage-Ringes 1e angeordnet ist, kann die aus der Einheit 2 ungewollt austretende Flüssigkeit durch eine der Bohrungen 1d des Mittelbereichs 1c auslaufen und über die Nut 7 letztlich durch die Auslassbohrung 8 abfließen.

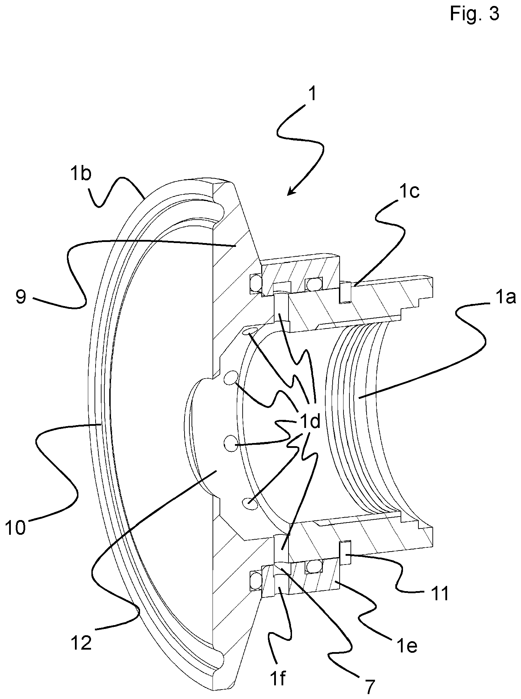

Die Figur 3 zeigt eine perspektivische Schnittansicht eines bevorzugten Ausführungsbeispiels der Verbindungsvorrichtung 1, ohne die Einheit 2 und den Sensor 3. Der erste Montageabschnitt 1a weist ein Gewinde auf, mit dem der Sensor 3 an die Verbindungsvorrichtung 1 montiert werden kann. Hierbei kann anstatt dem Gewinde auch ein glatter Absatz für eine Presspassung des Sensors 3 an die Verbindungsvorrichtung 1 auf der Seite des ersten Montageabschnitts 1a vorgesehen sein.

Der zweite Montageabschnitt 1b umfasst einen Flansch 9, mit dem die Tri-Clamp-Verbindung herstellbar ist. Der Flansch 9 weist eine Nut 10 auf, in der die Dichtungsanordnung 5a vorgesehen ist. Der Mittelbereich 1c weist bei dem gezeigten Ausführungsbeispiel zehn Bohrungen 1d auf, wobei durch zumindest eine der Bohrungen 1d auslaufende Flüssigkeit austreten kann. Alle Bohrungen 1d sind auf der Innenseite des Mittelbereichs 1c über die Sammelnut 12 miteinander verbunden, so dass sich ein Hohlraum zwischen der Innenseite des Mittelbereichs 1c und einer Außenfläche des Sensors 3 bildet, in den beispielsweise durch eine Undichtigkeit der Dichtungsanordnung 5a Flüssigkeit von der Einheit 2 eintreten kann.

Der Leckage-Ring 1e deckt vollständig mit seiner Nut 7 die Bohrungen 1d ab, so dass die ungewollt auslaufende Flüssigkeit nur in die Nut 7 des Leckage-Ringes 1e fließen kann. Durch den Leckage-Auslass 1f des Leckage-Ringes 1e kann die Flüssigkeit ins Freie austreten, so dass einem Nutzer auf diese Weise die Undichtigkeit angezeigt werden kann.

Ferner ist der Leckage-Ring 1e auf einer Seite mit dem Flansch 9 des zweiten Montageabschnitts 1b und auf der anderen Seite mit einem Sicherungsring 11 in Kontakt, so dass der Leckage-Ring 1e drehbar in Position gehalten ist.

Eine Montage der obigen Verbindungsvorrichtung 1 wird wie folgt durchgeführt. Der Sensor 3 wird in einem Schritt a) mit dem ersten Montageabschnitt 1a der Verbindungsvorrichtung 1 verbunden. Hierbei kann die Verbindung entweder durch Aufschrauben oder durch Aufpressen des Sensors 3 auf den ersten Montageabschnitt 1a geschehen. Der zweite Montageabschnitt 1b wird mittels der Flanschverbindung 5 mit der Einheit 2 verbunden. Selbstverständlich kann die Verbindungsvorrichtung 1 auch zuerst mit der Einheit 2 und erst danach mit dem Sensor 3 verbunden werden.

Nach dem Verbinden der Verbindungsvorrichtung 1 mit der Einheit 2 und dem Sensor 3 wird durch Drehen der Verbindungsvorrichtung 1 über den Mittelbereich 1c in einem Schritt b) der Sensor 3 in eine gewünschte Position so ausgerichtet, dass beispielsweise ein Ablesen eines Displays des Sensors 3 einfach durchführbar ist oder Anschlüsse des Sensors 3 derart ausgerichtet sind, dass eine einfache Verkabelung des Sensors 3 durchgeführt werden kann.

Wenn der Sensor 3 ausgerichtet ist, wird in einem Schritt c) der Leckage-Ring 1e gedreht, so dass der Leckage-Auslass 1f in einem Bereich bzw. an der tiefsten Position des Umfangs des Leckage-Ringes 1e in der Betriebsposition angeordnet ist. Hierdurch ist eine Standardvorgabe, beispielsweise der Lebensmittelindustrie, einfach zu erfüllen, nämlich die Positionierung einer Leckageanzeige an der möglichst untersten Stelle der Verbindung zwischen dem Sensor 3 und der das Fluid enthaltenden Einheit 2.

Zusätzlich bleibt der Sensor 3 in seiner Position justierbar, so dass je nach Bedarf, beispielsweise für eine bessere Ablesbarkeit oder für eine einfache Verkabelung des Sensors 3, der Sensor 3 nach der Verbindung mit der Einheit 2 ausgerichtet werden kann, ohne die unterste Stelle des Leckage-Auslasses 1f in der Betriebsposition aufgeben zu müssen.

### Bezugszeichenliste

- 1: Verbindungsvorrichtung
- 1a: Erster Montageabschnitt
- 1b: Zweiter Montageabschnitt
- 1c: Mittelbereich
- 1d: Bohrung
- 1e: Leckage-Ring
- 1f: Leckage-Auslass
- 2: Einheit
- 3: Sensor
- 4: Schraubverbindung
- 5: Flanschverbindung
- 5a: Dichtungsanordnung
- 6: Dichtungen
- 7: Nut
- 8: Auslassbohrung
- 9: Flansch
- 10: Nut
- 11: Sicherungsring
- 12: Sammelnut

## Patentansprüche

1. Verbindungsvorrichtung (1) zum Verbinden eines Sensors (3) mit einer ein Fluid enthaltenden Einheit (2), umfassend
einen ersten Montageabschnitt (1a), an den der Sensor (3) montierbar ist, einen zweiten Montageabschnitt (1b), der an die Einheit (2) montierbar ist, einen zwischen dem ersten und dem zweiten Montageabschnitt (1a und 1b) liegenden Mittelbereich (1c), und
einen den Mittelbereich (1c) abdeckenden Leckage-Ring (1e), der gegenüber dem Mittelbereich (1c) abgedichtet und drehbar ist, wobei der Leckage-Ring (1e) einen Leckage-Auslass (1f) auf seinem Umfang aufweist,
**dadurch gekennzeichnet, dass** der Leckage-Ring (1e) ausgebildet ist, nach einem Ausrichten des Sensors (3) mittels Drehen der Verbindungsvorrichtung (1) drehbar zu sein, wobei durch Drehen des Leckage-Ringes (1e) gegenüber dem Mittelbereich (1c) der Leckage-Auslass (1f) im Bereich einer tiefsten Position des Umfangs des Leckage-Ringes (1e) in eine Betriebsposition anordenbar ist, damit eventuell vorhandenes Fluid ablaufen kann, und
**dass** der Mittelbereich (1c) mehrere Bohrungen (1d) auf seinem Umfang aufweist, und
**dass** der Leckage-Ring (1e) eine umlaufende Nut (7) und eine nach außen gerichtete Auslassbohrung (8) aufweist, wobei die Nut (7) sämtliche Bohrungen (1d) des Mittelbereichs (1c) abdeckt und mit der Auslassbohrung (8) verbunden ist und zusammen mit der Auslassbohrung (8) den Leckage-Auslass (1f) des Leckage-Ringes (1d) bildet.

2. Verbindungsvorrichtung (1) nach Anspruch 1, **dadurch gekennzeichnet, dass** der erste Montageabschnitt (1a) eine Schraubverbindung (4) umfasst.

3. Verbindungsvorrichtung (1) nach Anspruch 1 oder 2, **dadurch gekennzeichnet, dass** der zweite Montageabschnitt (1b) eine Flanschverbindung (5), insbesondere eine Tri-Clamp-Verbindung, umfasst.

4. Verbindungsvorrichtung (1) nach einem der vorhergehenden Ansprüche 1 bis 3, **dadurch gekennzeichnet, dass** die Verbindung des ersten Montageabschnitts (1a) mit dem Sensor (3) und die Verbindung des zweiten Montageabschnitts (1b) mit der Einheit (2) hermetisch dicht ausgebildet sind.

5. Verfahren zum Montieren eines Sensors (3) mittels einer Verbindungsvorrichtung (1) nach einem der vorhergehenden Ansprüche 1 bis 4 an eine ein Fluid enthaltende Einheit (2), umfassend die Schritte:
a) Montieren des Sensors (3) an einem ersten Montageabschnitt (1a) der Verbindungsvorrichtung (1) und Montieren eines zweiten Montageabschnitts (1b) der Verbindungsvorrichtung (1) an die Einheit (2), **gekennzeichnet durch**
b) Ausrichten des Sensors (3) in eine gewünschte Position des Sensors (3), und
c) Drehen eines Leckage-Ringes (1e) der Verbindungsvorrichtung (1), um einen am Umfang des Leckage-Ringes (1e) vorgesehenen Leckage-Auslass (1f) in einem Bereich einer tiefsten Position des Umfangs des Leckage-Ringes (1e) in eine Betriebsposition anzuordnen.

## Claims

1. Connecting device (1) for connecting a sensor (3) to a unit (2) containing a fluid, comprising
a first mounting section (1a) to which the sensor (3) is mountable,
a second mounting section (1b) mountable to the unit (2),
a central section (1c) located between the first and second mounting sections (1a, 1b), and
a leakage ring (1e) covering the central section (1c) which is sealed and rotatable relative to the central section (1c), wherein the leakage ring (1e) has a leakage outlet (1f) on its periphery,
**characterized in that** the leakage ring (1e) is designed to be rotatable after alignment of the sensor (3) by means of rotation of the connecting device (1), wherein by rotating the leakage ring (1e) relative to the central section (1c) the leakage outlet (1f) is arranged in a region of a lowest position of the periphery of the leakage ring (1e) in an operating position so that any fluid present can drain, and
**in that** the central section (1c) has a plurality of holes (1d) on its periphery, and **in that** the leakage ring (1e) has a circumferential groove (7) and an outwardly directed outlet bore (8), the groove (7) covering all bores (1d) of the central section (1c) and being connected to the outlet bore (8) and forms the leakage outlet (1f) of the leakage ring (1e) together with the outlet bore (8).

2. Connecting device (1) according to claim 1, **characterized in that** the first mounting section (1a) comprises a screw connection (4).

3. Connecting device (1) according to claim 1 or 2, **characterized in that** the second mounting section (1b) comprises a flange connection (5), in particular a tri-clamp connection.

4. Connecting device (1) according to one of the preceding claims 1 to 3, **characterized in that** the connection of the first mounting section (1a) to the sensor (3) and the connection of the second mounting section (1b) to the unit (2) are hermetically sealed.

5. A method of mounting a sensor (3) by means of a connecting device (1) according to one of the preceding claims 1 to 4 to a unit (2) containing a fluid, comprising the steps:
a) mounting the sensor (3) to a first mounting section (1a) of the connecting device (1) and mounting a second mounting section (1b) of the connecting device (1) to the unit (2), **characterized by**
b) aligning the sensor (3) to a desired position of the sensor (3), and
c) rotating a leakage ring (1e) of the connecting device (1) to arrange a leakage outlet (1f) provided on the periphery of the leakage ring (1e) into an operating position in a region of a lowest position of the periphery of the leakage ring (1e).

## Revendications

1. Dispositif de connexion (1) pour connecter un capteur (3) à une unité (2) contenant un fluide, comprenant
une première section de montage (1a) sur laquelle le capteur (3) peut être monté, une deuxième section de montage (1b) qui peut être montée sur l'unité (2),
une section centrale (1c) située entre la première et la deuxième section de montage (1a, 1b), et
un anneau de fuite (1e) recouvrant la section centrale (1c) qui est étanche et rotatif par rapport à la section centrale (1c), dans lequel l'anneau de fuite (1e) a une sortie de fuite (1f) sur sa périphérie,
**caractérisé en ce que** l' anneau de fuite (1e) est configuré pour être rotatif après l'alignement du capteur (3) au moyen d'une rotation du dispositif de connexion (1), la sortie de fuite (1f) étant disposée par rotation de l' anneau de fuite (1e) par rapport à la section centrale (1c) dans une région d'une position la plus basse de la périphérie de l' anneau de fuite (1e) dans une position opérationnelle, afin que le fluide éventuellement présent puisse s'écouler, et
**en ce que** la section centrale (1c) présente une pluralité d alésages (1d) sur sa périphérie, et
**en ce que** l' anneau de fuite (1e) présente une rainure (7) périphérique et un alésage de sortie (8) dirigé vers l'extérieur, la rainure (7) recouvrant tous les alésages (1d) de la section centrale (1c) et étant reliée à l'alésage de sortie (8) et formant avec l'alésage de sortie (8) la sortie de fuite (1f) de l' anneau de fuite (1e).

2. Dispositif de connexion (1) selon la revendication 1, **caractérisé en ce que** la première section de montage (1a) comprend un raccord à vis (4).

3. Dispositif de connexion (1) selon la revendication 1 ou 2, **caractérisé en ce que** la deuxième section de montage (1b) comprend un raccord à bride (5), en particulier un raccord tri-clamp.

4. Dispositif de connexion (1) selon l'une des revendications précédentes 1 à 3, **caractérisé en ce que** la connexion de la première section de montage (1a) au capteur (3) et la connexion de la deuxième section de montage (1b) à l'unité (2) sont hermétiquement étanches.

5. Procédé de montage d'un capteur (3) au moyen d'un dispositif de connexion (1) selon l'une des revendications précédentes 1 à 4 sur une unité (2) contenant un fluide, comprenant les étapes:
a) montage du capteur (3) sur une première section de montage (1a) du dispositif de connexion (1) et montage d'une deuxième section de montage (1b) du dispositif de connexion (1) sur l'unité (2), **caractérisé par**
b) aligner le capteur (3) sur une position souhaitée du capteur (3), et
c) faire tourner un anneau de fuite (1e) du dispositif de connexion (1) pour disposer une sortie de fuite (1f) prévue sur la périphérie de l'anneau de fuite (1e) dans une région d'une position la plus basse de la périphérie de l'anneau de fuite (1e) dans une position opérationnelle.
